# EUROPÄISCHE PATENTSCHRIFT

(11) **EP 1 078 283 B1**
(45) Veröffentlichungstag und Bekanntmachung des Hinweises auf die Patenterteilung: **05.11.2003**
(21) Anmeldenummer: 99924952.7
(22) Anmeldetag: 12.05.1999
(51) Int. Cl.: G01V 3/08

(54) **KAPAZITIVES MESSVERFAHREN**
CAPACITIVE MEASURING METHOD
PROCEDE DE MESURE CAPACITIF

(30) Priorität: 13.05.1998 LU 90242
(43) Veröffentlichungstag der Anmeldung: 28.02.2001
(73) Patentinhaber: IEE INTERNATIONAL ELECTRONICS & ENGINEERING S.A., 6468 Echternach (LU)
(72) Erfinder: WENDT, Christoph, D-54292 Trier (DE); REUTER, Frank, D-54453 Nittel (DE)
(74) Vertreter: Beissel, Jean
(86) Internationale Anmeldenummer: EP9903269
(87) Internationale Veröffentlichungsnummer: WO99059003

(56) Entgegenhaltungen:
- WO-A-97/29391

## Beschreibung

Die vorliegende Erfindung betrifft ein kapazitives Meßverfahren mit mehreren Elektroden, das charakteristische Eigenschaften eines leitenden Körpers wie Form und Ort mittels kapazitiver Kopplung zwischen jeweils zwei dieser Elektroden über den elektrisch leitenden Körper ermittelt. Hierzu werden in einem kapazitivem Meßsystem die einzelnen Elektroden mit einer Wechselspannung beaufschlagt und die jeweils über die Elektroden abfließenden Ströme gemessen. Aus den Werten für die Meßspannung und Elektrodenstrom können dann die jeweiligen Koppelkapazitäten errechnet werden.

Solche Meßsysteme sind beispielsweise in den WO 97/29391 oder LU-A-88 828 beschrieben. Letzteres Meßsystem umfaßt mindestens eine Sendeelektrode und mindestens eine Empfangselektrode, die mit dem leitenden Körper kapazitiv gekoppelt sind. Die Empfangselektroden sind mit einer Auswerteschaltung verbunden, die die kapazitive Kopplung der Sendeantenne mit dem leitenden Körper durch Vergleich des gemessenen Signals mit einem Referenzsignal ermitteln.

Bei der Messung der kapazitiven Kopplung, mit einem geerdeten Meßgerät, stellt die Kapazität des leitenden Körpers gegen Masse eine Fehlerquelle dar. Um diesen Fehler zu beseitigen, wird in der Anmeldung LU 88 828 eine galvanische Trennung des Stromkreises vorgeschlagen. Dabei wird das Signal der Sendeelektrode von der Masse des Systems entkoppelt, um den Einfluß der parasitären Kapazität des zu detektierenden Körpers mit der Masse zu verringern.

Aufgabe der vorliegenden Erfindung ist es, ein kapazitives Meßverfahren der oben genannten Art vorzuschlagen, das besonders geeignet ist, um in Halbleiter-Technik angewandt zu werden.

Diese Aufgabe wird erfindungsgemäß gelöst durch ein Verfahren zur Messung der kapazitiven Kopplung von mindestens zwei Elektroden an einen elektrisch leitenden Körper, mit mindestens zwei Elektroden die jeweils von einer Wechselspannungsquelle mit einer Wechselspannung beaufschlagt werden, wobei die Wechselspannungsquellen derart ausgestaltet sind, daß die Spannung an den Elektroden eines Paares gegenphasig ist und so geregelt wird daß die Ströme in beiden Elektroden des Paares die gleiche Amplitude haben.

Bei diesem Meßverfahren werden die Wechselspannungsquellen zur Beaufschlagung der verschiedenen Elektroden derart geregelt, daß das Verhältnis der Spannung der beiden Spannungsquellen genau umgekehrt zum Verhältnis der Koppelkapazitäten ist. Das Verhältnis der Wechsel-Spannungen an den Spannungsquellen ist genau dann entsprechend eingestellt, wenn der Strom, der beiden Spannungsquellen entnommen wird, gleich groß ist. In diesem Fall stellt sich am leitenden Körper Massepotential ein und es wird kein Strom vom leitenden Körper nach Masse fließen, auch wenn dieser mit der Masse verbunden wird. Somit kann auch kein Meßfehler durch diesen Strom entstehen. Die Regelung der Spannungsquellen in Funktion vom Strom durch die Elektroden, kann kontinuierlich oder zeitdiskret erfolgen.

Eine Methode zur Messung der kapazitiven Koppelung von mindestens zwei Elektroden an einen elektrisch leitenden Körper, ist demgemäß dadurch gekennzeichnet, daß die Elektroden mit einer Wechselspannung beaufschlagt werden, wobei die Spannung an den Elektroden eines Paares gegenphasig ist und so geregelt wird, daß die Ströme in beiden Elektroden des Paares die gleiche Amplitude haben.

Im folgenden wird nun eine Ausgestaltung der Erfindung anhand der beiliegenden Figuren beschrieben. Es zeigen:
- Fig.1:: Eine schematische Darstellung des Meßprinzips
- Fig.2:: Ein Ersatzschaltbild einer ersten Ausgestaltung des vorliegenden Meßsystems,
- Fig.3:: Ein Ersatzschaltbild einer zweiten Ausgestaltung des vorliegenden Meßsystems.

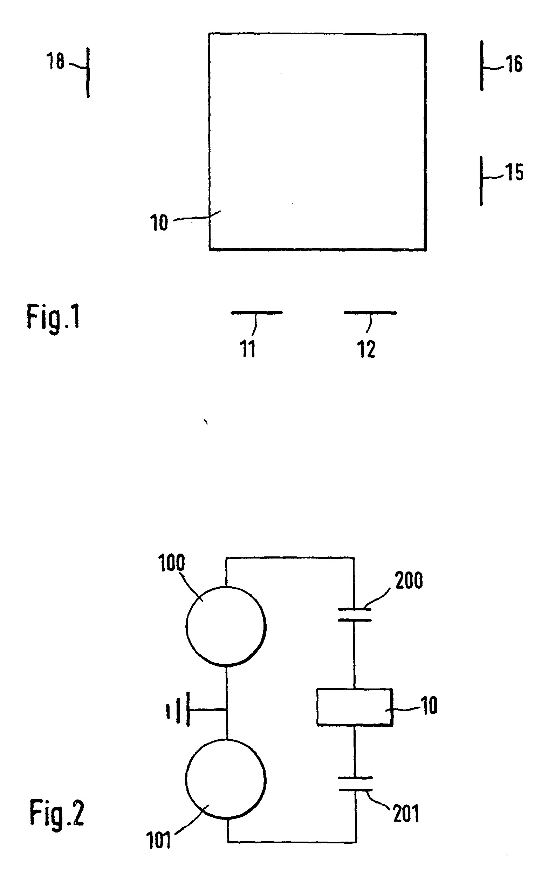

Fig. 1 veranschaulicht eine mögliche Anordnung verschiedener Elektroden 11, 12, 15, 16 und 18 um einen elektrisch leitenden Körper 10. Das Meßprinzip beruht auf der Messung der kapazitiven Kopplung zwischen jeweils zwei dieser Elektroden 11, 12, 15, 16 und 18 über den elektrisch leitenden Körper 10.

Zwei Elektroden, zwischen denen die Koppelkapazität gemessen werden soll, werden dabei mit einer Wechselspannung gleicher Frequenz, aber unterschiedlicher Polarität und Amplitude gespeist.

Das elektrische Ersatzschaltbild einer Anordnung mit zwei Elektroden ist in Figur 2 dargestellt. Diese zeigt die beiden synchronen Wechselspannungsquellen 100 und 101, die die jeweiligen Elektroden mit einer Wechselspannung beaufschlagen. Die Koppelkapazitäten 200 und 201 von den Spannungsquellen zum leitenden Körper 10 stellen beispielsweise die Kapazität zwischen der Elektroden 11 und dem leitenden Körper 10 sowie der Elektrode 12 und dem leitenden Körper dar.

Ist das Verhältnis der Spannungen der beiden Spannungsquellen 100 und 101 genau umgekehrt zum Verhältnis der Koppelkapazitäten 200 und 201, stellt sich am leitenden Körper 10 Massepotential ein. In diesem Fall wird kein Strom vom leitenden Körper nach Masse fließen, auch wenn es mit Masse verbunden wird. Somit kann auch kein Meßfehler durch diesen Strom entstehen. Das Verhältnis der Wechsel-Spannungen an den Spannungsquellen 100 und 101 ist genau dann entsprechend eingestellt, wenn der Strom, der beiden Spannungsquellen entnommen wird, gleich groß ist. Die Regelung der Spannungsquellen in Funktion vom Strom durch die Elektroden, kann kontinuierlich oder zeitdiskret erfolgen.

In einem Mehrelektroden-System nach Figur 1 bietet sich die Möglichkeit alle Elektrodenpaare im Zeitmultiplex sequentiell anzusteuern und somit das Prinzip aus Figur 2 unverändert einzusetzen.

Alternativ kann auch im Frequenzmultiplex gearbeitet werden so daß Spannungs-Quellen mit unterschiedlichen Frequenzen gleichzeitig die Elektroden ansteuern. In der Praxis bietet Codemultiplex, gegenüber Frequenzmultiplex, den Vorteil daß man ein verteiltes Frequenzspektrum erhält und somit die Störfestigkeit erhöht. Dabei werden Pseudo-Zufallsfolgen als Code auf die Wechselspannung moduliert so daß die Folge von jeder Spannungs-Quelle orthogonal zu denen aller anderen Spannungs-Quellen ist.

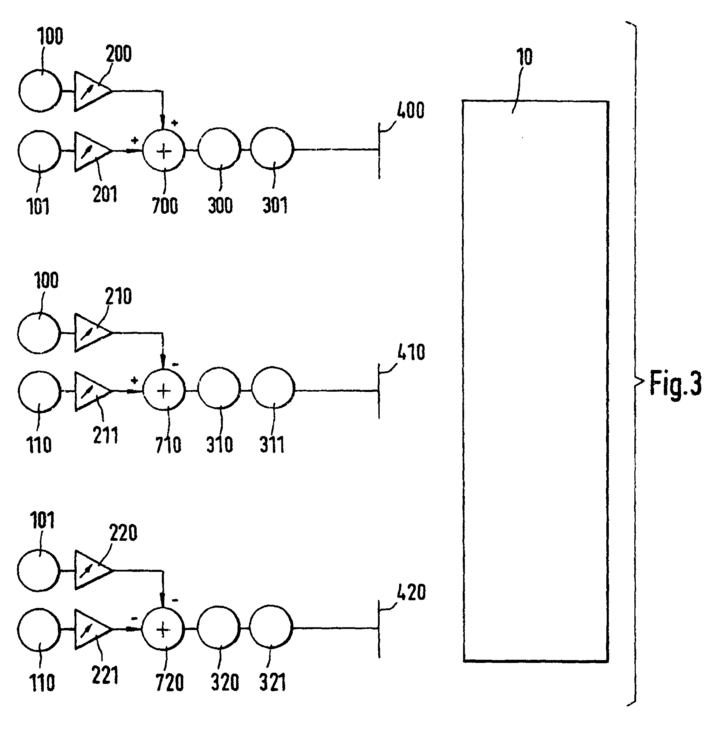

In Fig. 3 sind drei Wechselspannungsquellen 100, 101, 110 und 3 Elektroden 400, 410, 420 gezeigt. Jedem Elektrodenpaar 400-410, 400-420, 410-420 ist eine eigene Spannungsquelle 100, 101, 110 mit spezifischer Codesequenz zuzuordnen. Die Wechselspannung wird über variable Verstärker 200, 201, 210, 211, 220, 221 einem Addierer 700, 710, 720 zugeführt.

Jede Elektrode ist Teil von mehreren Elektrodenpaaren zwischen denen die kapazitive Koppelung gemessen wird. Die dem jeweiligen Elektrodenpaar zugeordneten modulierte Wechselspannung wird für jede Elektrode des Paares addiert bzw. subtrahiert so daß die zwei Elektroden jedes Elektrodenpaares mit unterschiedlicher Polarität angesteuert werden.

Die durch die Elektroden fließenden Ströme werden mittels Synchrondemodulatoren 300, 301, 310, 311, 320, 321 codeselektiv gemessen. 300 und 310 messen den Strom der durch die Quelle 100 verursacht wird, 301 und 320 messen den Strom der durch die Quelle 101 verursacht wird und 311 und 321 messen den Strom der durch die Quelle 110 verursacht wird. Mit den gemessenen Strömen werden die variablen Verstärker so geregelt, daß die beiden einer Quelle, einem Code zugeordneten Ströme gleich groß sind.

## Patentansprüche

1. Verfahren zur Messung der kapazitiven Kopplung von zwei Elektroden an einen elektrisch leitenden Körper, wobei jede der Elektroden jeweils mit einer Wechselspannung beaufschlagt wird und wobei die Wechselspannungen an den beiden Elektroden gegenphasig sind, **dadurch gekennzeichnet, dass** die Wechselspannungen an den beiden Elektroden derart geregelt werden, dass die Ströme in den beiden Elektroden die gleiche Amplitude aufweisen.

2. Verfahren nach Anspruch 1, **dadurch gekennzeichnet, dass** die Regelung der Wechselspannungen in Funktion vom Strom durch die jeweilige Elektrode erfolgt.

3. Verfahren nach Anspruch 1 oder 2, **dadurch gekennzeichnet, dass** die Regelung der Wechselspannungen kontinuierlich oder zeitdiskret erfolgt.

## Claims

1. Method for measuring the capacitive coupling from two electrodes to an electrically conductive body, with each of the electrodes each having an AC voltage applied to them, and with the AC voltages on the two electrodes being in antiphase, **characterized in that** the AC voltages on the two electrodes are regulated such that the currents in the two electrodes have the same amplitude.

2. Method according to Claim 1, **characterized in that** the AC voltages are regulated as a function of the current through the respective electrode.

3. Method according to Claim 1 or 2, **characterized in that** the AC voltages are regulated continuously or on a discrete-time basis.

## Revendications

1. Procédé de mesure du couplage capacitif de deux électrodes à un corps électriquement conducteur, chacune des électrodes étant alimentée par une tension alternative propre et les tensions alternatives sur les deux électrodes étant en opposition de phase, **caractérisé en ce que** les tensions alternatives sur les deux électrodes sont réglées de telle façon que les courants dans les deux électrodes aient la même amplitude.

2. Procédé selon la revendication 1, **caractérisé en ce que** le réglage des tensions alternatives est réalisé en fonction du courant passant dans l'électrode correspondante.

3. Procédé selon la revendication 1 ou 2, **caractérisé en ce que** le réglage des tensions alternatives est réalisé soit en continu, soit à temps discret.
